# EUROPEAN PATENT APPLICATION

(11) **EP 4 701 398 A1**
(43) Date of publication of application: **25.02.2026**
(21) Application number: 25191792.8
(22) Date of filing: 25.07.2025
(51) Int. Cl.: H10W 20/00, H10W 70/40, H10W 20/44, H10P 74/00, H10B 80/00

(54) **DEVICE COMPRISING AN EXPOSED CONDUCTIVE LAYER AND A METHOD OF FABRICATION OF THE DEVICE**

(30) Priority: 07.08.2024 FR 2408751
(71) Applicant: STMicroelectronics International N.V., 1228 Plan-les-Ouates, Geneva (CH)
(72) Inventor: MERMOZ, Sebastien, 38190 BERNIN (FR); BIANCHI, Raul Andres, 73800 MYANS (FR); INARD, Alain, 38330 SAINT NAZAIRE LES EYMES (FR)
(74) Representative: Cabinet Beaumont

(57) **Abstract**

The present disclosure relates to an electronic system comprising a first device (100) comprising:
- a semiconductor substrate (130) with an opening (135);
- a stack (140) comprising a plurality of metal layers (158, 159) and conductive vias; and
- a conductive layer (120) comprising aluminum having a first face in contact with the stack (140) and a second face, opposite the first face, partially exposed through the opening (135),
wherein the metal layers (158, 159) and the conductive vias of the stack (140) are made of a conductive material different from aluminum.

## Description

### Technical field

The present disclosure relates generally to electronic devices comprising an exposed conductive layer and a method of fabrication of such devices.

### Background art

For the fabrication of electronic devices, bonding one wafer to another widens the design possibilities. However, the design and fabrication processes of a connection pad accessible by other electronic devices has some challenges. In particular, in the case that the pad is used for testing purposes, it is often desirable that the pad permits a device forming part of one of the wafers to be tested prior to assembly, and devices formed in both wafers to be tested after assembly.

A drawback of existing solutions is that they provide no possibility of testing devices in one of the wafers prior to assembly, they require a high number of photolithography steps and/or the use of a high number of masks, which is costly.

### Summary of Invention

According to one aspect, there is provided an electronic system comprising a first device comprising:
- a semiconductor substrate with an opening;
- a stack comprising a plurality of metal layers and conductive vias; and
- a conductive layer comprising aluminum having a first face in contact with the stack and a second face, opposite the first face, partially exposed through the opening,
wherein the metal layers and the conductive vias of the stack are made of a conductive material different from aluminum.

According to one embodiment, the system further comprises a second device, the second device contacting the stack of the first device at a connection interface opposite to the semiconductor substrate. For example, the second device comprises a semiconductor substrate covered by a stack comprising one or more metal layers and conductive vias connected to the one or more metal layers and passing through one or more dielectric layers. For example, the first and second devices comprise metallic contacts, with the metallic contacts of the first device connected to the metallic contacts of the second device at the connection interface.

According to one embodiment, the conductive layer is at least partially buried in the semiconductor substrate.

According to one embodiment, the conductive layer is separated from the semiconductor substrate by one or more conductive layers of the stack.

According to one embodiment, the conductive material of the metal layers and the conductive vias of the stack is copper.

According to one embodiment, the conductive layer comprises a central layer made of aluminum and a top layer and a bottom layer.

According to one embodiment, the bottom layer is made of a material comprising tantalum, preferably tantalum nitride.

According to one embodiment, the top layer is formed of at least one of titanium nitride, silicon nitride and tantalum nitride.

According to one embodiment, the conductive layer has a thickness comprised in the range 1µm to 2µm and preferably in the range 1.5µm to 2µm.

According to a further aspect, there is provided a manufacturing method of an electronic system comprising a first device, the method comprising:
- providing a semiconductor substrate;
- forming a conductive module on a first surface of the semiconductor substrate, the conductive module comprising i) a stack comprising a plurality of metal layers and conductive vias, and ii) a conductive layer comprising aluminum and a first face in contact with the stack, wherein the metal layers and the conductive vias of the stack are made of a conductive material different from aluminum; and
- etching the semiconductor substrate on a second surface opposite to the first surface to create an opening to partially expose a second face, opposite the first face, of the conductive layer.

According to one embodiment, the method further comprises:
- providing a second device;
- bonding the second device to the stack of the first device at a connection interface opposite to the semiconductor substrate.

According to one embodiment, forming the conductive module comprises forming the conductive layer by:
- etching a trench inside of the semiconductor substrate, to reach a depth inferior or equal to the thickness of the conductive layer;
- growing an aluminum layer to fill the trench.

According to one embodiment, forming the conductive layer further comprises etching a portion the aluminum layer to obtain the conductive layer.

According to one embodiment, forming the conductive module further comprises forming the stack and wherein forming the conductive layer is performed before forming stack.

According to a further aspect, there is provided an image sensor or a memory cell comprising the system described above.

### Brief description of drawings

The foregoing features and advantages, as well as others, will be described in detail in the following description of specific embodiments given by way of illustration and not limitation with reference to the accompanying drawings, in which:
Figure 1A is a cross-section view illustrating a device, for example forming part of a first wafer, according to an example embodiment of the present disclosure;
Figure 1B is a cross-section view illustrating a device comprising the device of Figure 1A bonded to a further device, for example forming part of a second wafer according to an example embodiment of the present disclosure;
Figure 2 is a cross-section view illustrating a device comprising a first device, for example forming part of a first wafer bonded to a further device, for example forming part of a second wafer, according to another example embodiment of the present disclosure;
Figure 3 is a cross-section view illustrating a device comprising a first device, for example forming part of a first wafer bonded to a further device, for example forming part of a second wafer, according to another example embodiment of the present disclosure; and
Figure 4A, Figure 4B, Figure 4C, Figure 4D, Figure 4E, Figure 4F, Figure 4G, Figure 4H, Figure 4I, Figure 4J, Figure 4K, Figure 4L, Figure 4M, Figure 4N and Figure 4O are cross-section views of successive steps of a fabrication process of the device of Figure 1A according to an example embodiment of the present disclosure.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, process steps involved in the fabrication of an electronic device such as photolithography, etching and material deposition are known to those skilled in the art and have not been described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

In the present disclosure, unless specified otherwise, the expressions "around", "approximately", "substantially" and "in the order of" signify within 10 %, and preferably within 5 %.

In the present disclosure, unless specified otherwise, whenever example ranges are given, the limit values of the ranges are considered to be included within the range.

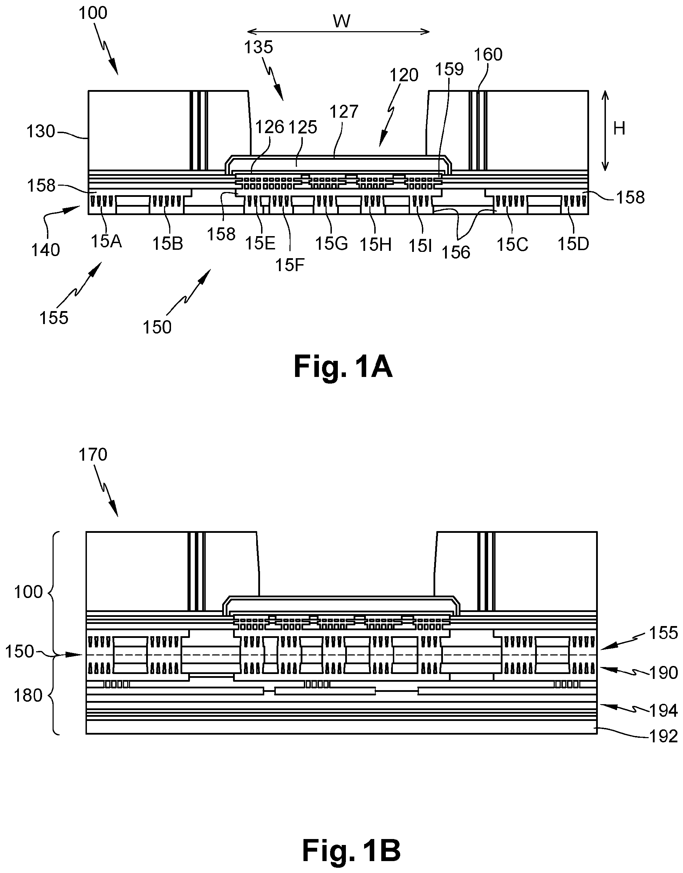

Figure 1A is a cross-section view illustrating a device 100, for example forming part of a first wafer, according to an example embodiment of the present disclosure.

The device 100 comprises a substrate 130. The substrate 130 is for example a semiconductor substrate, such as a substrate formed of or comprising silicon.

The device 100 for example comprises interconnection layers forming a stack 140. The stack 140 for example comprises one or more metal layers 158, 159, for example of copper, and for example comprises conductive vias connected to the one or more metal layers and passing through one or more dielectric layers. The one or more metal layers and the conductive vias are for example formed of a conductive material different from aluminum.

The device 100 further comprises a conductive layer 120 comprising aluminum. For example, as illustrated in Figure 1A, the conductive layer 120 may comprise an aluminum sub-layer 125 sandwiched between further sub-layers 126, 127 formed of other conductive materials. For example, the sub-layer 126 formed on an underside of the aluminum sub-layer 125 is formed of tantalum, tantalum nitride, or other materials comprising tantalum. The sub-layer 127 formed on the top surface of the aluminum sub-layer 125 is for example formed of titanium nitride, silicon nitride or tantalum nitride.

One advantage of having the conductive layer 120 comprising aluminum and having the one or more metal layers 158, 159 and the conductive vias of the stack 140 made of a conductive material different from aluminum (e.g., made of copper) is that the conductive layer 120 can be positioned at any depth of the device 100, thus simplifying the manufacturing process. Since the conductive layer is made of a different conductive material than the metal layers 158, 159 and the conductive vias, they are made in two distinct process steps, thus allowing an easier provision of all the features that allow these elements to perform their respective functions in the device.

According to one embodiment illustrated in Figure 1A, the conductive layer 120 is at the interface between the substrate 130 and the stack 140. For example, the conductive layer 120 is at least partially buried inside the substrate 130.

Part of a surface of the conductive layer 120 is exposed and accessible through an opening 135 in the substrate 130 and is for example configured to be connected to an external device (not illustrated in FIG 1A). In particular, the conductive layer 120 is for example a connection pad of the device 100. Figure 1A is not drawn to scale, and for example, in practice, a width W of the opening 135 is 5 to 10 times larger than a height H of the opening 135. For example, the width W is in the range 40µm to 60µm and the height H is in the range 4µm to 12µm.

According to one embodiment illustrated in Figure 1A, the conductive layer 120 is formed in a layer closer to the substrate 130 than a first metal layer 159 of the stack 140.

According to one embodiment, the device 100 further comprises a connection interface 150 on a first surface of the device 100. The first surface is for example a surface of the stack 140 opposite to the surface in contact with the substrate 130. The connection interface 150 comprises one or more metallic contacts individually referenced 15A to 15I and collectively referenced 155 and the connection interface 150 is configured for connecting the first wafer to a second wafer (not illustrated in FIG 1A). The metallic contacts 155 are for example connected to at least one of the one or more metal layers of the stack 140 by conductive vias and at least one of the metallic contacts 155 is connected to the conductive layer 120 for example by one or more conductive vias 156 and one or more metal layers 158, 159. In the example of Figure 1A, the metallic contacts 15A to 15D are connected to the metal layer 158 and five metallic contacts 15E to 15I are connected to the conductive layer 120 by means of conductive vias 156 and the metal layers 158, 159. Although five metallic contacts 15E to 15I are represented, in alternative embodiments there may be more or less conductive contacts 155 connected to the conductive layer 120. The metallic contacts 155 are configured to be connected to corresponding metallic contacts of another device (not illustrated in FIG 1A).

The conductive layer 120 is for example only connected to one or more metallic contacts 155 of the connection interface 150, and not to other components of the device 100. In other words, the conductive layer 120 is used (exclusively) for contacting a further device connected to the metallic contacts 155.

The device 100 for example comprises one or more isolation rings 160 inside the substrate 130 configured to isolate the device 100 from charges accumulating close to the opening 135 and from any wire-bond mistakenly contacting a portion of the substrate 130 located inside the one or more isolation rings 160.

Figure 1B is a cross-section view illustrating a system 170 comprising the device 100 of Figure 1A bonded to a further device 180, for example forming part of a second wafer according to an example embodiment of the present disclosure.

According to one embodiment, the connection interface 150 of the first wafer of the device 100 is bonded, for example by a technique of hybrid bonding (HB), to a connection interface of the second wafer, such that the first and second wafers are stacked face-to-face. The metallic contacts 155 of the connection interface 150 are for example connected to one or more metallic contacts 190 of the connection interface of the second wafer. The positioning of the metallic contacts 155 of the first wafer for example matches that of the second wafer such that they are aligned and make electrical contacts.

Advantageously, the device 100 which comprises the conductive layer 120 is positioned on top of the further device 180. For example, the further device 180 does not comprise a respective conductive layer. An advantage of positioning the device 100 which comprises the conductive layer 120 on top is that a deep etching step is not performed to create the opening 135 for contacting the conductive layer 120. A distance between the conductive layer 120 and the top surface of the device 100 is for example small enough to avoid a deep etching step. In other words, the conductive layer placed in the top device is close to the free surface of the system at which the etching process takes place.

Another advantage of positioning the device 100 which comprises the conductive layer 120 on top is that the manufacturing of the stacks of the device 100 and the further device 180 is simplified since there is little (or no) constraint on the build-up of the metal layers 158, 159 and the conductive vias. For example, the portion of the system 170 that is located between the conductive layer 120 and the substrate 130, where the opening 135 is made, should be free of any metal layer and conductive via. By placing the conductive layer 120 in the top device, this constraint is reduced or avoided.

The second wafer for example comprises a substrate 192 covered by a stack 194 for example comprising one or more metal layers, for example of copper, and for example comprising conductive vias connected to the one or more metal layers and passing through one or more dielectric layers. The second wafer for example comprises conductive layers and electronic components that are connected to the device 100 and/or to the conductive layer 120 via the metallic contacts 155, 190.

One advantage of having the conductive layer 120 in contact with the substrate 130 is that the opening 135 only exposes the conductive layer 120 and that the stack 140 is not exposed by the opening 135. This reduces the risk of electrostatic charges accumulating during the process step creating the opening 135, especially since this process step happens towards the end of the fabrication process. Another advantage of these embodiments of Figure 1A and Figure 1B is that the stack 140 is not exposed to the environment and moisture which increases reliability. For example, the use of seal rings to protect exposed faces of the stack 140 can be avoided.

Although a single device 100 of the first wafer and a single device 180 of the second wafer are illustrated in the Figures 1A and 1B, the first wafer and the second wafer can each comprise a multitude of similar devices, for example hundreds or thousands of devices, which will for example be separated to form discrete two-tier devices during a dicing operation.

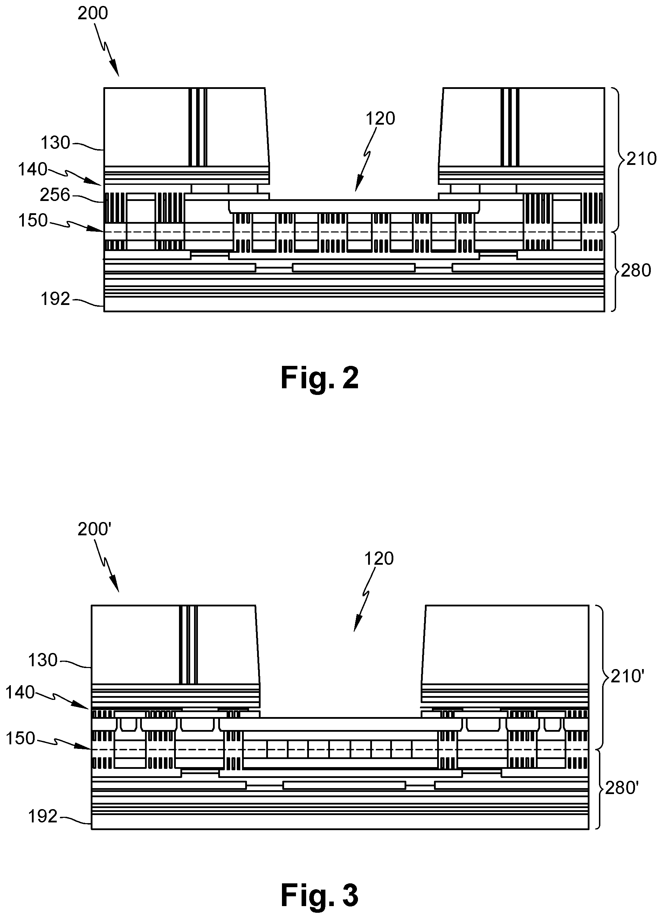

Figure 2 is a cross-section view illustrating a device 200 comprising a first device 210, for example forming part of a first wafer bonded to a further device 280, for example forming part of a second wafer, according to another example embodiment of the present disclosure.

The device 200 is similar to the device 170 of Figure 1B and like features have been referenced with the same reference numerals. A difference between the devices 170 and 200 is that in the device 200, the conductive layer 120 is not in contact with the substrate 130.

According to one embodiment, the conductive layer 120 is in a dedicated conductive layer of the first device 210, separated from the substrate 130 by one or more intermediate layers. For example, the intermediate layers correspond to metal levels of the device, each metal level comprising metal tracks and being separated from adjacent metal levels by a corresponding dielectric layer. The conductive layer 120 is for example only connected to the connection interface 150 of the first wafer. The conductive layer 120 is for example formed at the same level of the metal level (for example, in the metal level) of the first device 210 that is furthest from the substrate 130, or in other words the closest to the connection interface 150. In particular, the conductive layer 120 does not directly contact the substrate but there is a portion of the stack 140 interposed between the conductive layer and the substrate.

In the example of Figure 2, long hybrid-bonding vias (HBV) are formed to connect the connection interface 150 to metal levels of the stack 140, which are for example located closer to substrate 130 than the conductive layer 120.

One advantage of the embodiment of Figure 2 is that it can be implemented with relatively few modifications with respect to a standard fabrication process, for example with the addition of a single photolithography step.

Figure 3 is a cross-section view illustrating a device 200' comprising a first device 210', for example forming part of a first wafer bonded to a further device 280', for example forming part of a second wafer, according to another example embodiment of the present disclosure.

The device 200' is similar to the device 200 of Figure 2 with the difference that, the conductive layer 120 is implemented in a metal level of the device that comprises additional metal tracks that serve to provide additional interconnections within the stack 140. These metal tracks are for example formed during the same process step as the formation of the conductive layer 120, and are thus formed of the same metal or metals as the conductive layer 120.

In the example of Figure 3, in addition to the conductive layer 120 being connected to the connection interface 150, the conductive layer 120 is also connected to other metal levels of the first device 210'.

Compared to the device 170 of Figure 1B and to the device 200 of Figure 2, the device 200' can be fabricated using at least one less photolithography step and the use of one less mask because the generation of the conductive layer 120 can be performed simultaneously with other structures of the device 200'. This leads to a reduction of cost.

The conductive layer 120 is for example formed in the metal level of the first device 210' that is furthest from the substrate 130, that is to say the closest to the connection interface 150. In particular, the conductive layer 120 does not directly contact the substrate but there is a portion of the stack 140 interposed between the conductive layer and the substrate.

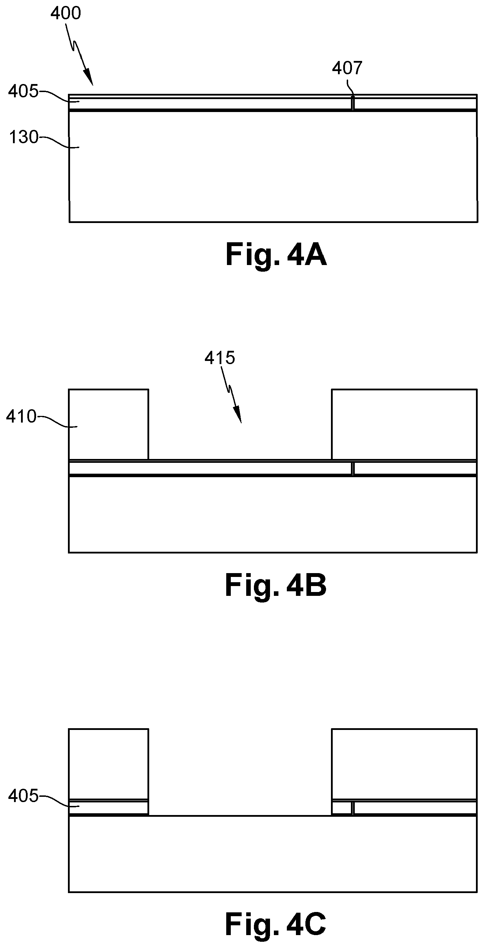

Figures 4A to Figure 4O are cross-section views of successive steps of a fabrication process of the device 100 of Figure 1A according to an example embodiment of the present disclosure.

Some elements of Figures 4A to 4O are identical to elements of Figure 1A. These elements are labeled with the same references and will not be described again in detail.

Figure 4A illustrates a device 400 corresponding to an example starting point for the fabrication process of the device 100 of Figure 1A.

The device 400 comprises the substrate 130, for example corresponding to a portion of the first wafer.

According to one embodiment, the device 400 comprises a dielectric layer 405 covering the substrate 130. The dielectric layer 405 for example comprises a sub-layer formed of silicon carbonitride (SiCN) optionally covered by a sub-layer formed of a dielectric. For example, the dielectric is one having an ultralow dielectric constant, for example below 2.5. As an example, the dielectric is a compound of silicon dioxide and organosilicate glass, for example SiCOH. The dielectric layer 405 is for example deposited using chemical vapor deposition. The thickness of the sub-layer of SiCN is for example in the range 10nm to 30nm and the thickness of the dielectric sub-layer is for example in the range 35nm to 55nm. The dielectric layer 405 for example has a thickness in the range 400nm to 500nm.

The device 400 for example comprises a contact 407 passing through the dielectric layer 405, for example composed of tungsten.

Figure 4B illustrates the device 400 of Figure 4A after a step of photolithography.

Photolithography is for example used to generate a first mask layer 410 at the surface of the dielectric layer 405 comprising an opening 415 exposing the surface of the dielectric layer 405.

Figure 4C illustrates the device of Figure 4B after an optional etching step.

In the embodiments where the substrate 130 is covered by the dielectric layer 405, the dielectric layer 405 is etched, at the location of the opening 415, for example using dry etching. In the presence of multiple dielectric sub-layers, the step of Figure 4C may be repeated to etch the dielectric sub-layers successively until the substrate layer 130 is exposed.

In other embodiments, not illustrated, the device 400 of Figure 4A does not comprise the dielectric layer 405. The first mask layer 410 is generated at the surface of the substrate 130 and comprises the opening 415 to expose the surface of the substrate 130. The etching step illustrated in Figure 4C can then be omitted.

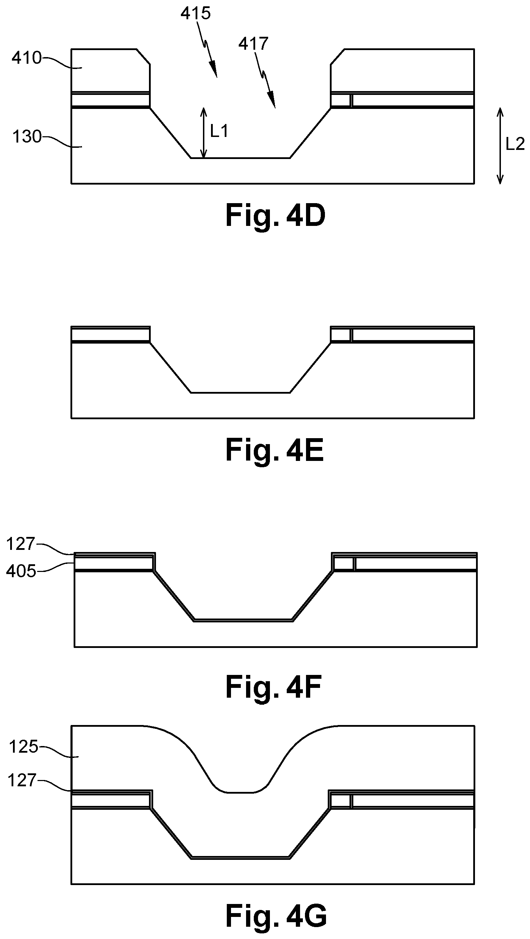

Figure 4D illustrates the device of Figure 4C after an etching step.

The substrate layer 130 is etched, for example using wet etching, through the opening 415. For example, a cavity 417 with a height L1 is formed in the substrate layer 130, the height L1 being smaller than the thickness L2 of the substrate layer 130. The height L1 is for example in the range 1µm to 2µm, for example 1.2µm to 1.8µm.

Figure 4E illustrates the device of Figure 4D after the removal of the first mask layer 410.

For example, the first mask layer 410 is stripped.

Figure 4F illustrates the device of Figure 4E after one or more optional deposition steps.

According to one embodiment, a dielectric layer (not illustrated) is deposited to cover the surface of the device. For example, a layer of oxide, for example tetraethyl orthosilicate (TEOS), is deposited. The thickness of the dielectric layer is for example in the range 5nm to 20nm.

According to one embodiment, the conductive sub-layer 127 of the conductive layer 120 of Figure 1A is deposited at the surface of the dielectric layer, or directly to cover the surface of the device of Figure 4E. For example, a first sub-layer formed of titanium nitride or silicon nitride is deposited, for example with a thickness in the range 15nm to 35nm. For example, a second sub-layer formed of tantalum nitride is deposited at the surface of the first sub-layer, for example with a thickness in the range 10nm to 30nm.

Figure 4G illustrates the device of Figure 4F after the deposition of the aluminum sub-layer 125 of Figure 1A, for example using sputtering. The sub-layer of aluminum 125 is deposited at the surface of the device of Figure 4F. The thickness of the sub-layer of aluminum 125 is for example in the range 1µm to 2µm and for example 1.4µm to 1.5µm.

In some embodiments, the thickness of the sub-layer of aluminum 125 is larger than the height L1 of the cavity formed in the substrate layer 130.

One advantage of the optional dielectric layer and conductive sub-layer 127 deposited at the step illustrated in Figure 4F is that they prevent a direct contact between the substrate layer 130 and the aluminum sub-layer 125. These layers for example form a diffusion barrier, an etch-stop barrier, or both a diffusion barrier and an etch-stop barrier, in order to protect the aluminum sub-layer 125.

In some embodiments, the step illustrated in Figure 4F is omitted and the sub-layer of aluminum 125 is directly deposited on the surface of the substrate layer 130.

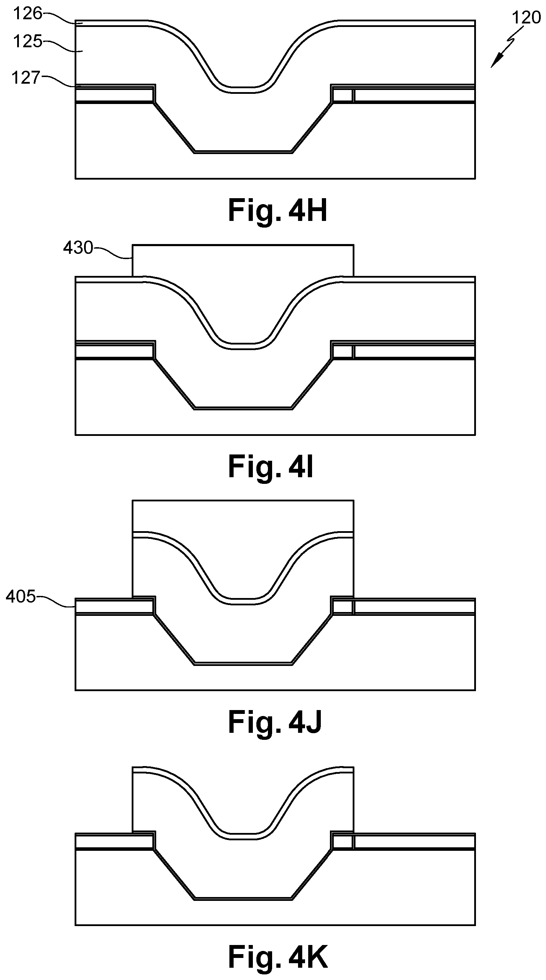

Figure 4H illustrates the device of Figure 4G after one or more optional deposition steps.

According to one embodiment, the conductive sub-layer 126 is deposited on the surface of the aluminum sub-layer 125. For example, a first sub-layer formed of tantalum is deposited, for example with a thickness in the range 5nm to 15nm. For example, a second sub-layer formed of tantalum nitride is deposited at the surface of the first sub-layer of tantalum, for example with a thickness in the range 150nm to 170nm.

The sub-layers 127, 125, 126 deposited in the steps illustrated in Figure 4F, 4G and 4H together form the conductive layer 120 of Figure 1A. This is for example achieved using a damascene process.

Figure 4I illustrates the device of Figure 4H after a step of photolithography.

Photolithography is for example used to generate a second mask layer 430 at the surface of the device of Figure 4H or directly at the surface of the device of Figure 4G. The second mask layer 430 is positioned above the cavity 417 and is for example wider than the opening 415 of the first mask layer 410.

Figure 4J illustrates the device of Figure 4I after one or more etching steps.

One or more etching steps, for example using dry etching, are used to etch the conductive and/or dielectric layers covering the dielectric layer 405 to expose the dielectric layer 405 outside of the region covered by the second mask layer 430.

In the embodiments where the device 400 of Figure 4A does not comprise the dielectric layer 405, the substrate layer 130 is exposed outside of the region covered by the second mask layer 430.

Figure 4K illustrates the device of Figure 4J after the removal of the second mask layer 430.

For example, the second mask layer 430 is stripped.

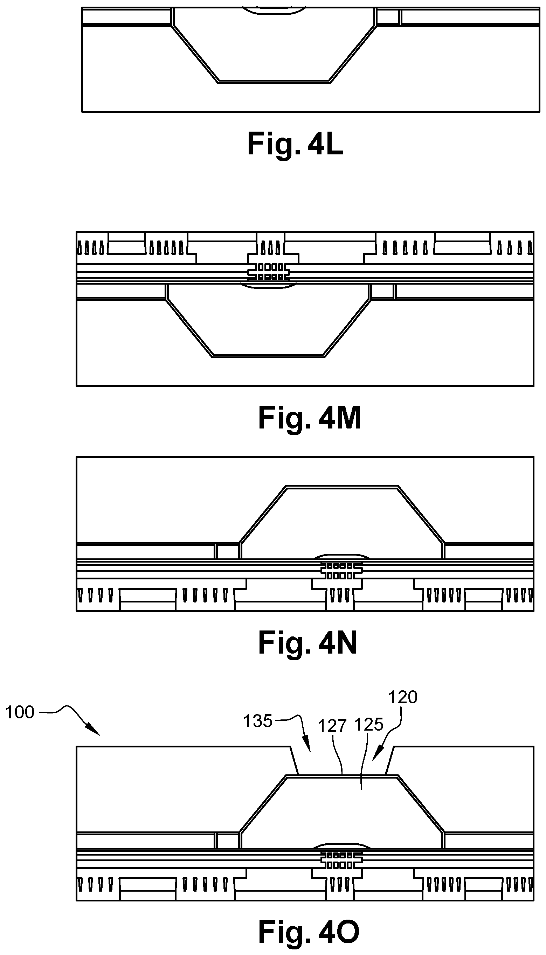

Figure 4L illustrates the device of Figure 4K after a step of thinning to remove the excess material of the conductive layer 120 in order to obtain a flat surface, for example flush with the dielectric layer 405. The thinning for example involves chemical mechanical polishing.

Figure 4M illustrates the device of Figure 4L after several deposition steps.

The stack 140 of one or more conductive and/or dielectric layers described in Figure 1A is for example formed by a succession of deposition steps.

According to one embodiment, metallic vias are formed, for example by electroplating, to connect the conductive layer 120 to the connection interface 150. For example, other metallic vias are formed to connect metal tracks to the connection interface 150.

Figure 4N illustrates the device of Figure 4M flipped over such that the substrate layer 130 is facing upwards.

Figure 4O illustrates the device of Figure 4N after a step of etching.

According to some embodiments, a step of photolithography is performed to deposit a third mask layer (not illustrated) with an opening at the position of the opening 135 of Figure 1A.

The substrate layer 130 is etched, for example using wet etching, to create the opening 135 to expose the conductive layer 120. In the embodiments where the conductive layer 120 comprises the sub-layer 127, it is for example the sub-layer 127 that is exposed. The sub-layer 127 for example comprises an etch-stop barrier to protect the sub-layer of aluminum 125. The sub-layer 127 is for example harder than aluminum and helps, during subsequent testing of the device, to absorb and spread a force resulting from the application of a probing tip at the surface of the sub-layer 127, the probing tip being applied to measure or apply a current or a voltage.

The third mask layer is then removed following the step of etching.

The opening 135 has for example a width in the range 40µm to 100µm and a height in the range 3µm to 15µm.

In embodiments where the sub-layer of aluminum 125 is directly deposited on the surface of the substrate layer 130, the etching of the substrate layer 130 in Figure 4O results in exposing the aluminum sub-layer 125.

The device resulting from the step described in relation with Figure 4O corresponds to the device 100 of Figure 1A.

In the embodiments described in the present description, the conductive layer 120 for example comprises aluminum and does not comprise copper. One advantage of using aluminum over copper for the sub-layer 125 is to obtain an area free of copper at the location of the opening 135, thereby simplifying the process step. Another advantage of using aluminum over copper is that aluminum provides passivation and does not diffuse oxygen.

One advantage of having the conductive layer 120 on the first wafer that comprises the opening 135 is that the device 100 of the first wafer can be tested independently of the device 180 of the second wafer and without being bonded to the second wafer. This results in a reduced cost per yield with respect to having the one or more conductive layers 120 formed inside the second device 180.

Furthermore, the embodiments described herein require relatively few photolithography steps and masks, which results in relatively low fabrication costs. Furthermore, the described fabrication processes are compatible with the formation of a planar surface compatible with the formation of optical lenses.

The device 100, 170, 200, 200' is for example an image sensor, for example a 3D stacked back-side illumination (BSI) image sensor, a memory cell or a processor.

The device 100, 170, 200, 200' is for example comprised in a 3D stacked device involving wafer-to-wafer bonding or die-to-wafer bonding in its fabrication process.

The device 100, 170, 200, 200' is for example comprised in a component implemented in an electronic device such as a phone, a computer, a camera or a display screen, for example used in the telecommunication industry or the automotive industry.

Various embodiments and variants have been described. Those skilled in the art will understand that certain features of these embodiments can be combined and other variants will readily occur to those skilled in the art. In particular, although it has been described that the first wafer is configured to be bonded to a second wafer, in alternative embodiments, a die-to-wafer process could be used in which the first wafer is separated into individual devices, which are individually bonded to the second wafer.

Finally, the practical implementation of the embodiments and variants described herein is within the capabilities of those skilled in the art based on the functional description provided hereinabove.

## Claims

1. An electronic system (170, 200, 200') comprising a first device (100, 210, 210') comprising:
- a semiconductor substrate (130) with an opening (135);
- a stack (140) comprising a plurality of metal layers (158, 159) and conductive vias; and
- a conductive layer (120) comprising aluminum having a first face in contact with the stack (140) and a second face, opposite the first face, partially exposed through the opening (135),
wherein the metal layers (158, 159) and the conductive vias of the stack (140) are made of a conductive material different from aluminum.

2. The system (170, 200, 200') according to claim **1,** further comprising a second device (180, 280, 280'), the second device (180, 280, 280') contacting the stack (140) of the first device at a connection interface (150) opposite to the semiconductor substrate (130).

3. The system (170, 200, 200') according to claim 1 or 2, wherein the conductive layer (120) is at least partially buried in the semiconductor substrate (130).

4. The system (170, 200, 200') according to claim 1 or 2, wherein the conductive layer (120) is separated from the semiconductor substrate (130) by one or more conductive layers of the stack (140).

5. The system (170, 200, 200') according to any of claims 1 to 4, wherein the conductive material of the metal layers (158, 159) and the conductive vias of the stack (140) is copper.

6. The system (170, 200, 200') according to any of claims 1 **to 5,** wherein the conductive layer (120) comprises a central layer (125) made of aluminum and a top layer (127) and a bottom layer (126).

7. The system (170, 200, 200') according to claim 6, wherein the bottom layer (126) is made of a material comprising tantalum, preferably tantalum nitride.

8. The system (170, 200, 200') according to claim 6 or 7, wherein the top layer (127) is formed of at least one of titanium nitride, silicon nitride and tantalum nitride.

9. The system (170, 200, 200') according to any of claims 1 to 8, wherein the conductive layer (120) has a thickness comprised in the range 1µm to 2µm and preferably in the range 1.5µm to 2µm.

10. A manufacturing method of an electronic system (170, 200, 200') comprising a first device (100, 210, 210'), the method comprising:
- providing a semiconductor substrate (130);
- forming a conductive module on a first surface of the semiconductor substrate (130), the conductive module comprising i) a stack (140) comprising a plurality of metal layers (158, 159) and conductive vias, and ii) a conductive layer (120) comprising aluminum and a first face in contact with the stack (140), wherein the metal layers (158, 159) and the conductive vias of the stack (140) are made of a conductive material different from aluminum; and
- etching the semiconductor substrate (130) on a second surface opposite to the first surface to create an opening (135) to partially expose a second face, opposite the first face, of the conductive layer (120).

11. The method according to claim 10, further comprising:
- providing a second device (180, 280, 280');
- bonding the second device to the stack (140) of the first device at a connection interface (150) opposite to the semiconductor substrate (130).

12. The method according to claim 10 or 11, wherein forming the conductive module comprises forming the conductive layer (120) by:
- etching a trench inside of the semiconductor substrate (130), to reach a depth inferior or equal to the thickness of the conductive layer (120);
- growing an aluminum layer to fill the trench.

13. The method according to claim 12, wherein forming the conductive layer (120) further comprises etching a portion of the aluminum layer to obtain the conductive layer (120).

14. The method according to claim 12 or 13, wherein forming the conductive module further comprises forming the stack (140) and wherein forming the conductive layer (120) is performed before forming stack (140).

15. An image sensor or a memory cell comprising the system (170, 200, 200') according to any of claims 1 to **9.**
